# EUROPEAN PATENT SPECIFICATION

(11) **EP 2 772 944 B1**
(45) Date of publication and mention of the grant of the patent: **29.11.2017**
(21) Application number: 12836476.7
(22) Date of filing: 26.09.2012
(51) Int. Cl.: H01L 31/0232, G01J 1/02, G01J 1/04

(54) **INFRARED SENSOR AND HOLDER**
INFRAROTSENSOR UND HALTEELEMENT
CAPTEUR À INFRAROUGE ET CORPS DE RETENUE

(30) Priority: 30.09.2011 JP 2011217361
(43) Date of publication of application: 03.09.2014
(73) Proprietor: Asahi Kasei Microdevices Corporation, Tokyo 101-8101 (JP)
(72) Inventor: FUKUNAKA, Toshiaki, Tokyo 101-8101 (JP); MYORAKU, Yasutaka, Tokyo 101-8101 (JP)
(74) Representative: Hoffmann Eitle
(86) International application number: PCT/JP2012/006164
(87) International publication number: WO 2013/046676

(56) References cited:
- WO-A1-2009/148134
- JP-A- 2002 134 763
- JP-A- 2003 234 375
- JP-A- 2008 141 364
- JP-A- 2009 239 258
- JP-A- 2010 050 406

## Description

### Technical Field

The present invention relates to an infrared sensor and a holder that holds an infrared sensor element and an optical filter.

### Background Art

It has been thus far known that, when detecting a predetermined infrared ray using infrared sensor elements, wavelength selective filters that selectively transmit light having specif ic wavelengths to a sensor element are used. For example, FIGS. 2B and 6 in PTL 1 illustrate a configuration in which optical filters 16a and 16b are mounted to infrared sensor elements 13a and 13b through a holding member 15.

### Citation List

### Patent Literature

PTL 1: WO 2009/148134

### Summary of Invention

### Technical Problem

In PTL 1, in a case where the infrared sensor elements, the optical filters and holders are fixed to each other using an adhesive, in the configuration described in PTL 1, the opposing surfaces of the infrared sensor elements and the holders, and the opposing surfaces of the optical filters and the holders are respectively flat surfaces with no unevenness. In addition, the flat surfaces are adhered together through the adhesive. Therefore, there is a possibility that the adhesive may spread out during adhesion and come into contact with the optical filters, and the optical filters may be contaminated. The above problem will be described more specifically with reference to other conventional examples.

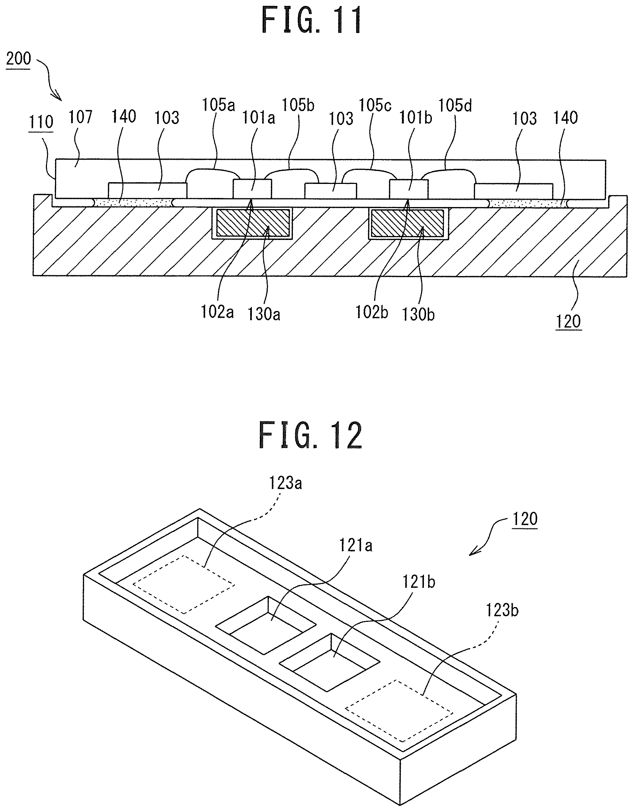

FIG. 11 is a cross-sectional view illustrating a configuration example of an infrared sensor 200 according to a conventional example. In addition, FIG. 12 is a perspective view illustrating a configuration example of a holder 120 provided in the infrared sensor 200. As illustrated in FIG. 11, the infrared sensor 200 includes an infrared sensor element 110, optical filters 130a and 130b, the holder 120, and an adhesive 140.

The infrared sensor element 110 includes infrared sensor chips 101a and 101b, lead frames 103, gold wires 105, and a mold resin 107. The infrared sensor chips 101a and 101b are connected with the lead frames 103 through the gold wires 105. In addition, the infrared sensor chips 101a and 101b, the lead frames 103, and the gold wires 105 are sealed with the mold resin 107 except for light reception surfaces 102a and 102b of the infrared sensor chips 101a and 101b and portions of the lead frames 103 which serve as external terminals.

As illustrated in FIGS. 11 and 12, the holder 120 is provided with accommodation parts 121a and 121b respectively to accommodate the optical filters 130a and 130b that transmit only light having predetermined wavelengths. The accommodation parts 121a and 121b are recess parts.

In a process for manufacturing the infrared sensor 200, the optical filters 130a and 130b are mounted in the accommodation parts 121a and 121b, and the adhesive 140 is applied respectively to adhesive application portions 123a and 123b in the holder 120. In addition, a side of the holder 120 including the adhesive application portions 123a and 123b and a side of the infrared sensor element 110 including the light reception surfaces 102a and 102b are placed opposite to each other, and the infrared sensor element 110 is relatively pressed against the holder 120 in the above-described state. Then, the holder 120 and the infrared sensor element 110 are adhered together.

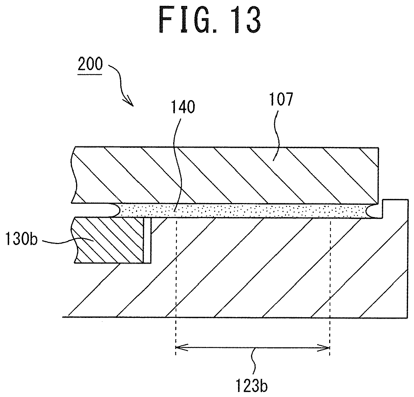

Here, in the above-described manufacturing process, in a case where a large amount of the adhesive 140 was applied (that is, a large amount of the adhesive 140 was applied unintentionally due to the irregularity or the like of the manufacturing process), there was a possibility that the adhesive 140 might spread out and the optical filters 130a and 130b might be contaminated as illustrated in FIG. 13. The possibility of the above-described contamination becomes particularly high in a case where the adhesive application portions 123a and 123b and a surface of each of the optical filters 130a and 130b are on the same surface (that is, in a case where the adhesive application portions and the surfaces are on the same height). In addition, when the optical filters 130a and 130b were contaminated due to the adhesive 140, there was a possibility that the transmittance of the optical filters 130a and 130b with respect to infrared rays might deteriorate and the optical filters might become incapable of satisfactorily working as filters.

In addition, it was necessary to apply the adhesive to side surface portions of the optical filters as well to hold the optical filters, and there was a case where the optical filters might be contaminated due to the adhesive from the side surface portions.

Therefore, the invention has been made in consideration of the above-described circumstances, and the purpose of the invention is to provide an infrared sensor and a holder which are capable of preventing optical filters from being contaminated by the adhesive.

Document JP 2008/141364 A(US 2008/0131112 A1) discloses an infrared sensor according to the preamble of claim 1.

Document JP 2002/134763 A discloses a groove made in a substrate of on which a semiconductor element is mounted.

### Solution to Problem

In order to solve the above-described problems, according to a first aspect of the invention, an infrared sensor is provided, including an infrared sensor element, which is a semiconductor package comprising a sensor chip; an optical filter which faces a light reception surface of the sensor chip; and a holder holding the infrared sensor element and the optical filter, in which the holder includes a recessed optical filter accommodation part for accommodating the optical filter provided on a facing surface of the holder which faces the infrared sensor element, wherein the optical filter is sandwiched between the holder and the infrared sensor element, an adhesion region comprising a recess part is provided at a location apart from the optical filter accommodation part on the facing surface of the holder, the adhesive being provided at the recess part of the adhesive region so as to adhere the holder and the infrared sensor element together through the applied adhesive at locations apart from the optical filter, and a groove for keeping adhesive leaked from the adhesion region within said groove is provided between the adhesion region and the optical filter accommodation part on the facing surface of the holder.

According to the above-described configuration, in a case where an adhesive leaks from the adhesion region in the holder due to the wetting and spreading of the adhesive when adhering the infrared sensor element and the holder together, it is possible to gather the leaked adhesive within the groove placed between the adhesion region and the optical filter accommodation part. Therefore, it is possible to suppress the adhesive that has leaked from the adhesion region from reaching the optical filter accommodation part. By using this holder structure, it is possible to control the wetting and spreading of the adhesive. Then, it is possible to prevent the adhesive from coming into contact with the optical filters accommodated in the optical filter accommodation part, and to prevent the optical filters from being contaminated due to the adhesive. When the contamination of the optical filters is prevented, the filter is capable of sufficiently exhibiting the function as a filter without deteriorating the infrared ray transmittance characteristics. In addition, it becomes possible to hold the optical filters in a holding member without supplying the adhesive to the optical filters.

Note that, the "infrared sensor element" of the invention corresponds to, for example, an infrared sensor element 10 described below.

In the above-described infrared sensor, the holder includes a recess part provided in the adhesion region. According to the above-described configuration, it is possible to apply the adhesive to the recess part in the adhesion region, and to suppress the adhesive from leaking from the adhesion region compared with a case where there is no recess part in the adhesion region.

In addition, in the above-described infrared sensor, a distance from the top of the facing surface (top surface) to a bottom surface of the groove may be greater than the distance from the facing surface to the bottom surface of the recess part. According to such a configuration, it is possible to keep a majority of the adhesive that has leaked from the recess part within the groove.

In addition, in the above-described infrared sensor, the groove may be placed so as to surround the outer circumference of the recess part. According to such a configuration, it is possible to suppress the adhesive that has leaked from the recess part from wetting and spreading out all (in four directions) around the recess part.

In addition, in the above-described infrared sensor, a hole portion having a diameter that is smaller than the optical filter accommodation part may be provided on a bottom surface of the optical filter accommodation part. According to such a configuration, the infrared sensor element is capable of receiving infrared rays through the through holes without impairing the function of the optical filter accommodation part that hold the optical filters.

In addition, in the above-described infrared sensor, opening parts that extend outside the holder from the groove may be provided in the holder. According to such a configuration, even in a case where air remains in the infrared sensor, it is possible to leak the remaining air through the opening parts. Then, it is possible to decrease forces generated due to the expansion of the remaining air in the infrared sensor, for example, the force generated due to the expansion of the remaining internal air which pushes the infrared sensor element away from the holder.

### Advantageous Effects of Invention

According to the invention, it is possible to prevent an adhesive from coming into contact with optical filters accommodated in accommodation part in a holder, and to prevent the optical filters from being contaminated by the adhesive.

### Brief Description of Drawings

FIG. 1 is a view illustrating a configuration example of an infrared sensor 100 according to an embodiment of the invention;
FIG. 2A is a view illustrating a configuration example of a holder 20 according to the embodiment of the invention;
FIG. 2B is a view illustrating a configuration example of a holder 20 according to the embodiment of the invention;
FIG. 3 is an enlarged view illustrating a part of the holder 20;
FIG. 4 is a view illustrating an application process of an adhesive 40;
FIG. 5 is a view illustrating an adhesion process of an infrared sensor element 10 and the holder 20;
FIG. 6A is a view illustrating a (first) modification example of the holder 20;
FIG. 6B is a view illustrating a (first) modification example of the holder 20;
FIG. 7 is a view illustrating a (second) modification example of the holder 20;
FIG. 8 is a view illustrating a (third) modification example of the holder 20;
FIG. 9 is a view illustrating a modification example of the infrared sensor 100;
FIG. 10A is a view illustrating a (fourth) modification example of the holder 20;
FIG. 10B is a view illustrating a (fourth) modification example of the holder 20;
FIG. 11 is a view illustrating a configuration example of an infrared sensor 200 according to a conventional example;
FIG. 12 is a view illustrating a configuration example of a holder 120 according to the conventional example; and FIG. 13 is a view for describing a problem.

### Description of Embodiments

Hereinafter, an embodiment according to the invention will be described with reference to the drawings. In the respective drawings described below, to the portions having similar configurations will be given similar reference signs, and description thereof may not be repeated.

### (Embodiment)

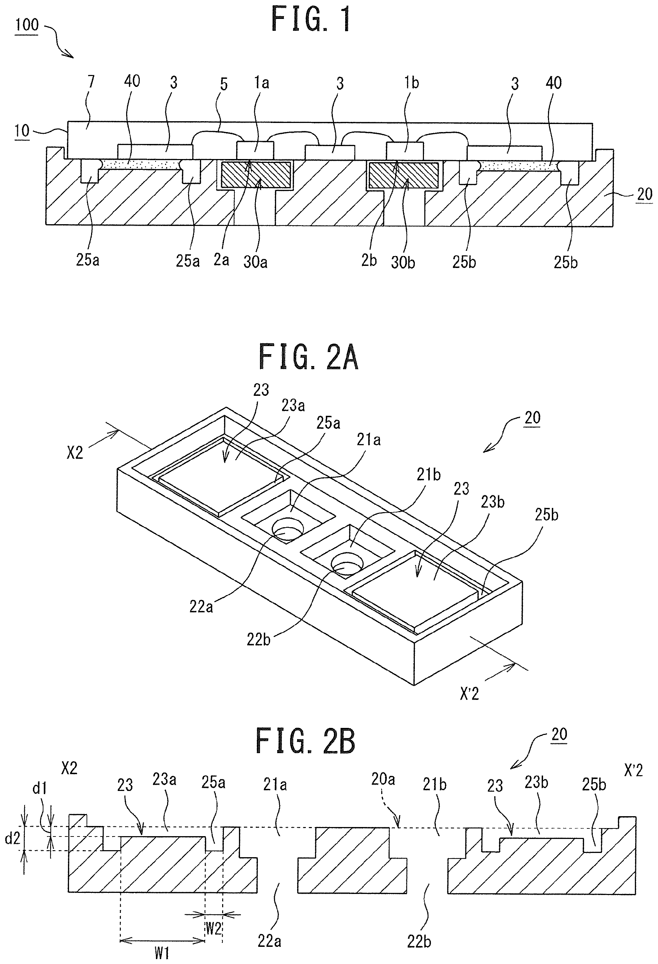

FIG. 1 is a cross-sectional view illustrating a configuration example of an infrared sensor 100 according to an embodiment of the invention. As illustrated in FIG. 1, the infrared sensor 100 includes an infrared sensor element 10, optical filters 30a and 30b that face a side of the infrared sensor element 10 including light reception surfaces, a holder 20 that holds the infrared sensor element 10 and the optical filters 30a and 30b, and an adhesive 40.

The infrared sensor element 10 is an element for detecting infrared rays. The infrared sensor element 10 is a semiconductor package including, for example, infrared sensor chips 1a and 1b, lead frames 3, gold wires 5, and a mold resin 7. Among the above-described components, the infrared sensor chips 1a and 1b are quantum-type photodiodes that are capable of detecting, for example, infrared rays of 2000 nm to 7400 nm. The infrared sensor chips 1a and 1b receive infrared rays at each of light reception surfaces 2a and 2b, and output, from a pad terminal (not illustrated) provided on a surface opposite to the light reception surfaces 2a and 2b, electric signals obtained from the photoelectric conversion of the received infrared rays. The lead frames 3 are terminal portions for outputting the electric signals obtained at the infrared sensor chips 1a and 1b outside the infrared sensor element 10. The lead frame 3 is obtained by, for example, performing a plating treatment of nickel (Ni)-palladium (Pd)-gold (Au) or the like on a copper (Cu) sheet.

The gold wires 5 connect the pad terminal included in the infrared sensor chips 1a and 1b and the lead frames 3. The electric signals are transferred from the pad terminal of the infrared sensor chips 1a and 1b to the lead frames 3 through the gold wires 5. The mold resin 7 forms the outer shape of the semiconductor package. The infrared sensor chips 1a and 1b, the lead frames 3, and the gold wires 5 are sealed with the mold resin 7 except for the light reception surfaces 2a and 2b and portions of the lead frames 3 which serve as the terminal portions.

Note that, in the embodiment, the infrared sensor chips 1a and 1b may be the same kind of chips, or may be chips classified into different types in terms of dimensions, materials, detectable wavelength ranges and the like.

The optical filters 30a and 30b have the function of select (which means, transmit with higher transmittance) a preset wavelength of an incident light ray. The optical filters 30a and 30b are sandwiched between the holder 20 and the infrared sensor element 10, and are placed in order to cover the light reception surfaces 2a and 2b of the infrared sensor chips 1a and 1b respectively.

Note that, in the embodiment, the optical filters 30a and 30b may be the same kind of filters, or may be filters classified into different types in terms of dimensions, materials, transmittable wavelength ranges and the like. For example, it is possible to provide the optical filter 30a having high transmittance only for long-wavelength components of infrared rays (long pass filter) and the optical filter 30b having high transmittance for only short-wavelength components of infrared rays (short pass filter). Next, a configuration example of the holder 20 will be described.

FIGS. 2A and 2B are views illustrating a configuration example of the holder 20 according to the embodiment of the invention. Specifically, FIG. 2A is a perspective view illustrating a side of the holder 20 which faces the infrared sensor element 10. In addition, FIG. 2B is a cross-sectional view of FIG. 2A taken along an X2-X2' line. As illustrated in FIGS. 2A and 2B, the holder 20 includes accommodation parts 21a and 21b that accommodate the optical filters 30a and 30b, recess parts 23a and 23b, and grooves 25a and 25b.

As illustrated in FIGS. 2A and 2B, the accommodation parts 21a and 21b are recess parts provided on a facing surface 20a on a side of the holder 20 which faces the infrared sensor element 10. The shape and size of the accommodation parts 21a and 21b respectively correspond to the shape and size of the optical filters 30a and 30b that are accommodated in the accommodation parts. It means that the accommodation parts 21a and 21b respectively have the same shape as the outer shape of the optical filters 30a and 30b, which are accommodated in the accommodation parts, and have the same dimensions (in the practice, these dimensions are usually slightly larger than those of the optical filters 30a and 30b to facilitate the insertion of the optical filters 30a and 30b). In addition, for example, through holes 22a and 22b having a diameter that is smaller than the recess parts 23a and 23b are respectively provided on bottom surfaces of the accommodation parts 21a and 21b. The through holes 22a and 22b are perforations from the adhesions side face through the opposite face of the holder 20. For example, the view angles of the light reception surfaces 2a and 2b through the optical filters 30a and 30b are respectively controlled using the through holes 22a and 22b. In addition, since the diameters of the through holes 22a and 22b are smaller than the accommodation parts 21a and 21b, the accommodation parts 21a and 21b have a function of holding the optical filters. That is, since the through holes 22a and 22b have a diameter that is smaller than the accommodation parts 21a and 21b, the infrared sensor element 10 is capable of receiving infrared rays through the through holes 22a and 22b without impairing the function of the accommodation parts 21a and 21b that hold the optical filters 30a and 30b.

In the embodiment, as illustrated in FIG. 2B, the recess parts 23a and 23b are provided in the adhesion region 23 placed at a location apart from the accommodation parts 21a and 21b on the holder 20. The recess parts 23a and 23b are shallow grooves provided on the facing surface 20a on the side of the holder 20 facing the infrared sensor element 10. The recess parts 23a and 23b are placed at locations apart from the accommodation parts 21a and 21b. In addition, the recess parts 23a and 23b are made available for the application of the adhesive (that is, in the infrared sensor 100, the adhesive 40 is applied to the recess parts 23a and 23b (refer to FIG. 1)). The planar shapes of the recess parts 23a and 23b are, for example, rectangular.

In addition, the grooves 25a and 25b are deep penetrations from the surface 20a of the holder 20. The groove 25a is placed at a location between the accommodation part 21a and the recess part 23a, and is placed so as to surround an outer circumference of the recess part 23a. The groove 25b is placed at a location between the accommodation part 21b and the recess part 23a, and is placed so as to surround an outer circumference of the recess part 23b.

That is, in the holder 20, when the depths of the bottom surfaces of the recess parts 23a and 23b from the facing surface 20a are represented by d1, and the depths of the bottom surfaces of the grooves 25a and 25b from the facing surface 20a are represented by d2, d2 is larger than d1 (d1<d2). In addition, the planar shape of the grooves 25a and 25b is, for example, a rectangular frame shape respectively.

Note that, in the embodiment, for example, the recess part 23a and the groove 25a are integrated together, and there is no partition such as a partition wall provided between the recess part 23a and the groove 25a. Similarly, the recess part 23b and the groove 25b are integrated together, and there is no partition such as a partition wall provided between the recess part 23b and the groove 25b. In a case where the groove 25a and the recess part 23a are integrated together, or in a case where the groove 25b and the recess part 23b are integrated together, since the grooves 25a and 25b are deeper than the recess parts 23a and 23b, it is possible to keep the wetting and spreading of the adhesive within the recess parts 23a and 23b, by using the surface tension of the adhesive.

Next, a process of applying the adhesive 40 to the recess parts 23a and 23b and a process of adhering the infrared sensor element 10 to the holder 20 through the applied adhesive 40 will be described.

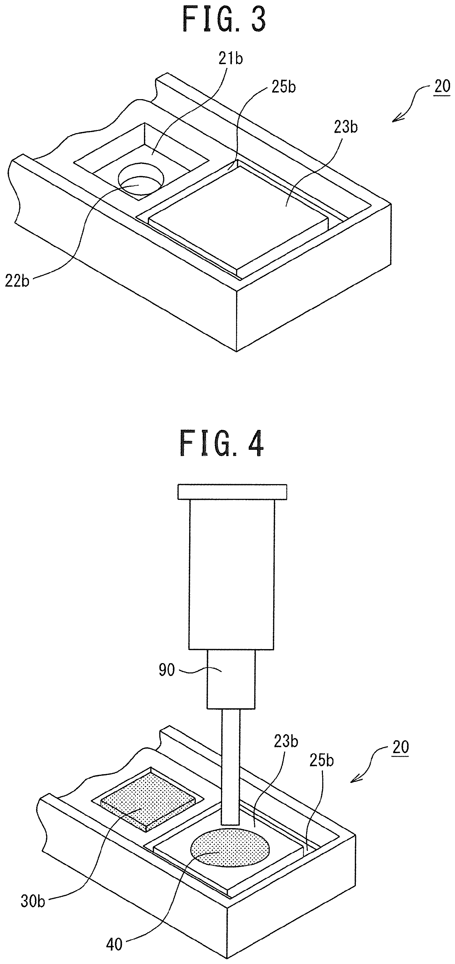

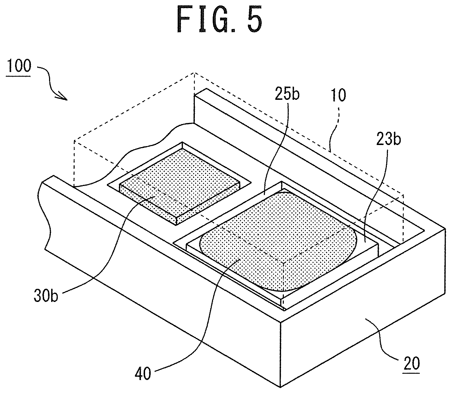

FIG. 3 is an enlarged view of a part of the holder 20. In addition, FIG. 4 is a view illustrating an application process of the adhesive 40. FIG. 5 is a view illustrating an adhesion process of the infrared sensor element 10 and the holder 20.

As illustrated in FIG. 3, the groove 25b is provided around the recess part 23b in the holder 20. Although it is not illustrated in FIG. 3, the groove 25a is also provided around the recess part 23a. In the embodiment, the optical filters 30a and 30b are respectively accommodated (mounted) in the accommodation parts 21a and 21b in advance before applying the adhesive 40 to the recess parts 23a and 23b. In addition, in the application process of the adhesive 40, as illustrated in FIG. 4, the adhesive 40 is applied to the bottom surfaces of the both recess parts 23a and 23b using, for example, a dispenser 90 (that is, by using a dispense method). Note that, the method for applying the adhesive 40 is not limited to dispense methods, and a stamp method may also be used.

In addition, in the application process illustrated in FIG. 4, the application amounts and application locations of the adhesive 40 are desirably adjusted to prevent the adhesive 40 from reaching the grooves 25a and 25b. When the adhesive 40 is prevented from reaching the grooves 25a and 25b in the application phase, it is also possible to more reliably prevent the adhesive 40 from spreading beyond the grooves 25a and 25b in the subsequent adhesion process.

Next, the facing surface 20a of the holder 20 and the light reception surfaces of the infrared sensor element 10 are placed opposite to each other. In addition, the infrared sensor element 10 is relatively pressed against the holder 20 as illustrated in FIG. 5 in the above-described state. Then, the infrared sensor element 10 and the holder 20 are adhered together, thereby completing the infrared sensor 100.

In the adhesion process illustrated in FIG. 5, the adhesive 40, during wetting and spreading, spreads out due to the relative pressing of the infrared sensor element 10 against the holder 20. In addition, when the application amount of the adhesive 40 is great due to the irregularity or the like of the manufacturing process, a case is also considered where some of the spreading adhesive 40 leaks from the recess parts 23a and 23b. However, the holder 20 is capable of keeping the adhesive 40 leaking from the recess parts 23a and 23b within the grooves 25a and 25b, and suppressing the adhesive 40 from spreading out to the accommodation parts 21a and 21b. Note that, the recess part may not be formed in the adhesion region 23, and, in such a case, it is also possible to keep the adhesive 40 within the grooves 25a and 25b.

In addition, when the adhesion regions 23 are provided at locations apart from the accommodation parts 21a and 21b, and the grooves 25a and 25b are formed, it is possible to adhere the holder 20 and the infrared sensor element 10 at locations apart from the optical filters 30a and 30b. Therefore, it becomes possible to hold the optical filters 30a and 30b through the accommodation parts 21a and 21b provided in the holder 20 without attaching the adhesive to the optical filters 30a and 30b.

Note that, the respective sizes of the recess parts 23a and 23b and the grooves 25a and 25b are desirably set, for example, as described below. That is, the depths d1 of the recess parts 23a and 23b from the facing surface 20a are desirably in a range of approximately 0.01 mm to 0.1 mm. In addition, the depths d2 of the grooves 25a and 25b from the facing surface20a are desirably deeper than the bottom surfaces of the recess parts 23a and 23b by a range of approximately 0.1 mm to 0.5 mm (that is, d2 is approximately d1+0.1 mm to 0.5 mm). In addition, the radiuses (widths) W1 of the recess parts 23a and 23b are desirably, for example, in a range of approximately 0.05 mm to 2 mm. The widths W2 of the grooves 25a and 25b are desirably in a range of approximately 0. 15 mm to 0.3 mm. Then, it is possible to more reliably prevent the adhesive 40 from wetting and spreading out beyond the grooves 25a and 25b while ensuring an adhesion force between the infrared sensor element 10 and the holder 20.

In addition, as a material for the holder 20, a liquid crystal polymer (LCP), polyphenylene sulfide resin (PPS), polyether ether ketone resin (PEEK) or a polyimide resin is desirably used when heat resistance is taken into account from the viewpoint of reflow resistance during mounting. As the material for the holder 20, additionally, it is also possible to use a copper material on which Ni-Pd-Au plating, silver plating or gold plating has been performed or a stainless steel-based material as a metal-based material. Furthermore, as a material for the adhesive 40, for example, an epoxy-based resin or a silicone-based resin is desirably used considering heat resistance and weldability.

### (The effects of the embodiment)

The embodiment of the invention exhibits the following effects.
(1) In a case where the adhesive 40 leaks from the adhesion region 23 in the holder 20 due to the wetting and spreading of the adhesive 40 when adhering the infrared sensor element 10 and the holder 20 together, it is possible to keep the leaked adhesive 40 within the grooves 25a and 25b. Therefore, it is possible to suppress the adhesive 40 that has leaked from the adhesion region 23 from reaching the accommodation parts 21a and 21b. That is, it is possible to control the wetting and spreading of the adhesive 40 using the structure of the holder 20. Then, it is possible to prevent the adhesive 40 from coming into contact with the optical filters 30a and 30b accommodated in the accommodation parts 21a and 21b, and to prevent the optical filters 30a and 30b from being contaminated due to the adhesive 40.
(2) In addition, the recess parts 23a and 23b are provided respectively in the adhesion region 23. Therefore, it is possible to apply the adhesive to the recess parts 23a and 23b, and, when compared with the case where there is no recess part in the adhesion region 23, it becomes easier to suppress the adhesive leakage from the adhesion region 23.
(3) In addition, in the holder 20, the depths d2 of the bottom surfaces of the grooves 25a and 25b from the facing surface 20a are larger than the depth d1 of each of the bottom surfaces of the recess parts 23a and 23b from the facing surface 20a (d1<d2). Therefore, compared with a case where d1≥d2, it is possible to keep a majority of the adhesive that has leaked from the recess parts 23a and 23b in the first recess parts.
(4) In addition, the recess parts 23a and 23b and the grooves 25a and 25b are integrally formed. Therefore, it becomes easy to keep the wetting and spreading of the adhesive within the grooves 25a and 25b using the surface tension of the adhesive.
(5) In addition, the grooves 25a and 25b are placed so as to surround the outer circumferences of the recess parts 23a and 23b. Therefore, it is possible to suppress the adhesive that has leaked from the recess parts 23a and 23b from wetting and spreading out all around (that is, in four directions) the recess parts 23a and 23b.
(6) In addition, the through holes 22a and 22b having a diameter that is smaller than the accommodation parts 21a and 21b are provided on the bottom surfaces of the accommodation parts 21a and 21b. Therefore, the infrared sensor element 10 is capable of receiving infrared rays through the through holes 22a and 22b without impairing the function of the accommodation parts 21a and 21b that hold the optical filters 30a and 30b.

### (Modification Examples)

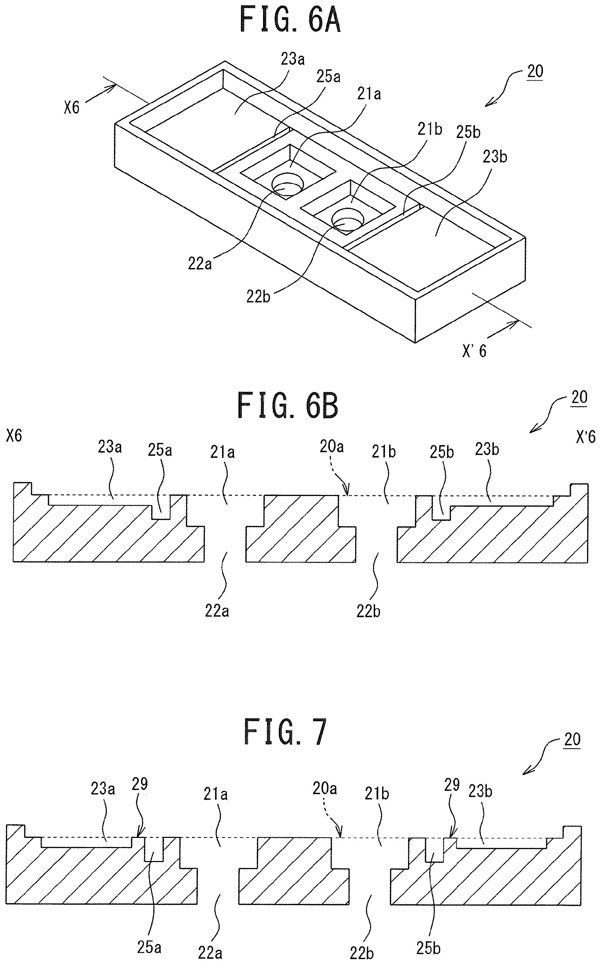

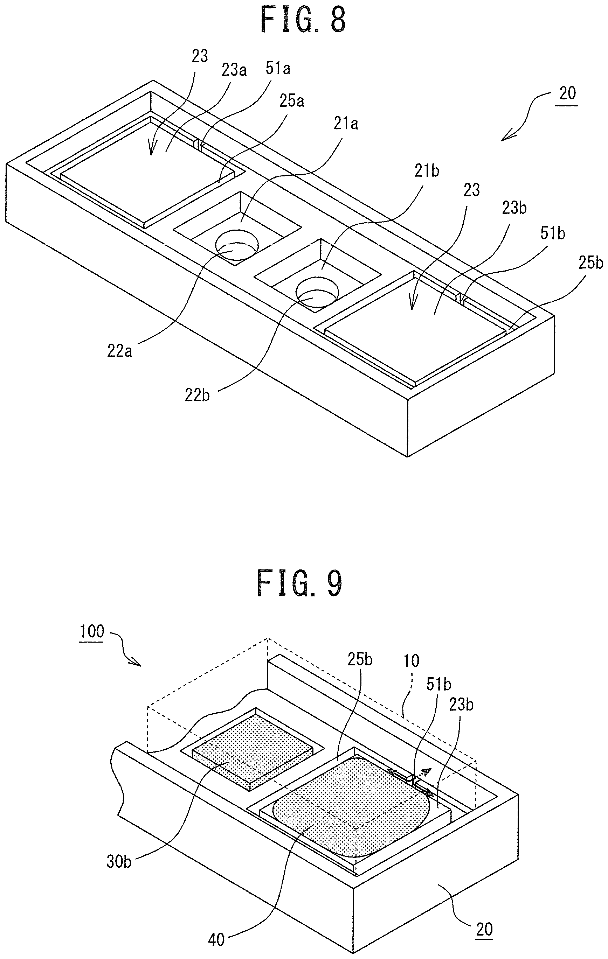

(1) Note that, in the embodiment, for example, the case where the grooves 25a and 25b are placed so as to respectively surround the outer circumferences of the recess parts 23a and 23b as illustrated in FIGS. 2A, 2B and the like has been described. However, in the invention, the disposition of the grooves 25a and 25b is not limited thereto. For example, a configuration is also possible in which the grooves 25a and 25b are placed only between the recess parts 23a and 23b and the accommodation parts 21a and 21b instead of surrounding the outer circumferences of the recess parts23a and 23b as illustrated in FIGS. 6A and 6B. Even in such a configuration, since it is possible to keep the adhesive that has leaked from the recess parts 23a and 23b within the grooves 25a and 25b, it is possible to prevent the optical filters 30a and 30b from being contaminated by the adhesive 40.
(2) In addition, in the embodiment, the case where the recess parts 23a and 23b and the grooves 25a and 25b are integrally formed has been described. However, in the invention, the recess parts 23a and 23b and the grooves 25a and 25b may not be integrally formed. For example, as illustrated in FIG. 7, partition walls 29 may be provided respectively between the recess parts 23a and 23b and the grooves 25a and 25b. Even in the above-described configuration, since it is possible to keep the adhesive 40 that has leaked from the recess parts 23a and 23b and has wetting and spreading beyond the partition walls 29 within the grooves 25a and 25b, it is possible to prevent the optical filters 30a and 30b from being contaminated by the adhesive 40.
(3) Furthermore, in the embodiment, opening parts for air ventilation may be provided in the holder 20. For example, as illustrated in FIG. 8, penetrated opening parts 51a and 51b that extend outside the holder 20 from the grooves 25a and 25b may be provided in the holder 20 as the opening parts for air ventilation. In such a configuration, it is possible to exhaust air between the facing surface of the holder 20 and the infrared sensor element 10 outside the holder 20 through the opening parts 51a and 51b when attaching the infrared sensor element 10 to the holder 20. Therefore, it becomes easy to attach the infrared sensor element 10 to the holder 20.

In addition, when air remains in the infrared sensor 100 (that is, between the facing surface of the holder 20 and the infrared sensor element 10) after attaching the infrared sensor element 10 to the holder 20, there is a possibility that the temperature of the remaining air may increase and the air may expand in the subsequent heating process and the like. For example, when mounting the infrared sensor 100 on a printed circuit board using a solder reflow method, there is a possibility that the remaining air may be heated and expanded.

Even in such a case, for example, when the opening parts 51a and 51b for air ventilation are provided in the holder 20 as illustrated in FIG. 9, it is possible to remove the remaining air through the opening parts 51a and 51b. Therefore, it is possible to decrease a force generated due to the expansion of the remaining air in the infrared sensor 100, for example, a force that is generated due to the expansion of the remaining air and pushes the infrared sensor element 10 apart from the holder 20. In addition, it is also possible to make the outside air to enter into the infrared sensor 100 through the opening parts 51a and 51b, during or after cooling. As described above, when the holder 20 includes the opening parts 51a and 51b, it is possible to decrease the pressure change caused by the remaining air in the infrared sensor 100.

(4) In addition, in the embodiment, the case where the infrared sensor element 10 includes a plurality of the infrared sensor chips 1a and 1b and a plurality of the optical filters 30a and 30b has been described. In addition, accordingly, the case where the holder 20 includes a plurality of the accommodation parts 21a and 21b, a plurality of the recess parts 23a and 23b, and a plurality of the grooves 25a and 25b has been described.

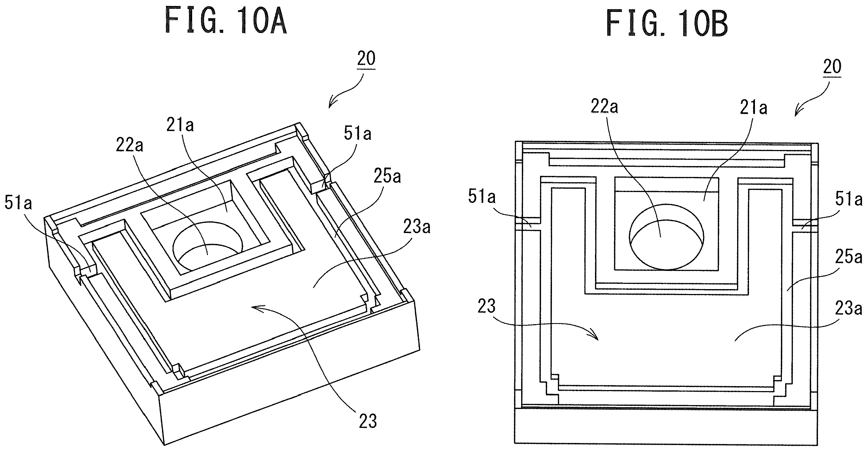

However, the invention is not limited thereto. The infrared sensor element 10 may include a single infrared sensor chip 1a and a single optical filter 30a instead of the plurality. In addition, for example, accordingly, the holder 20 may include a single accommodation part 21a, a single recess part 23a and a single groove 25a as illustrated in FIGS. 10A and 10B. Even in such a configuration, the same effects such as the effects (1) to (6) can be observed in this embodiment.

In addition, even in Modification Example (4), the opening parts for air ventilation may be provided in the holder 20. For example, the penetrated opening part 51a that extends outside the holder 20 from the groove 25a may be provided in the holder 20 as the groove for air ventilation as illustrated in FIGS. 10A and 10B. Then, the same effects as in Modification Example (3) are exhibited.

### (Others)

The invention is not limited to the above-described embodiment. It is possible to add modifications and the like in the design of an embodiment based on the knowledge of a person having ordinary skill in the technical field of the invention. The invention is defined by the appended claims.

### Reference Signs List

- 1a, 1b, 101a, 101b: infrared sensor chip
- 3, 103: lead frame
- 5, 105a, 105b, 105c, 105d: gold wire
- 7, 107: mold resin
- 10, 110: infrared sensor element
- 20, 120: holder
- 20a: facing surface
- 21a, 21b, 121a, 121b: accommodation part
- 22a, 22b: hole portion
- 23: adhesion region
- 23a, 23b, 123a, 123b: recess part
- 25a, 25b: groove
- 29: partition wall
- 30a, 30b, 130a, 130b: optical filter
- 40, 140: adhesive
- 51a, 51b: opening part (or groove)
- 90: dispensor
- 100, 200: infrared sensor

## Claims

1. An infrared sensor (100) comprising:
an infrared sensor element (10), which is a semiconductor package comprising a sensor chip (1a, 1b);
an optical filter (30a, 30b) which faces a light reception surface (2a, 2b) of the sensor chip (1a, 1b) and is placed in order to cover the light reception surface (2a, 2b) of the sensor chip (1a, 1b); and
a holder (20) holding the infrared sensor element and the optical filter; and
an adhesive (40) for bonding the infrared sensor element (10) and the holder (20),
wherein the holder includes
a recessed optical filter accommodation part (21a, 21b) for accommodating the optical filter, provided on a facing surface (20a) of the holder (20) which faces the infrared sensor element (10),
**characterized in that**
the optical filter (30a, 30b) is sandwiched between the holder (20) and the infrared sensor element (10),
an adhesion region (23) comprising a recess part (23a, 23b) is provided at a location apart from the optical filter accommodation part on the facing surface (20a) of the holder, the adhesive being provided at the recess part of the adhesive region (23) so as to adhere the holder (20) and the infrared sensor element (10) together through the applied adhesive (40) at locations apart from the optical filter (30a, 30b), and
a groove (25a, 25b) for keeping adhesive leaked from the adhesion region (23) within said groove is provided between the adhesion region and the optical filter accommodation part on the facing surface of the holder.

2. The infrared sensor according to claim 1, wherein a distance (d2) from the top of the facing surface (20a) of the holder to a bottom surface of the groove (25a, 25b) is greater than the distance (d1) from the top of the facing surface of the holder to a bottom surface of the recess part (23a, 23b).

3. The infrared sensor according to claim 1 or 2, wherein the groove (25a, 25b) is placed so as to surround an outer circumference of the recess part (23a, 23b).

4. The infrared sensor according to any one of claims 1 to 3, wherein a through hole (22a, 22b) having a diameter smaller than a diameter of the optical filter accommodation part (21a, 21b) is provided on a bottom surface of the optical filter accommodation part.

5. The infrared sensor according to any one of claims 1 to 4, wherein opening parts (51a, 51b) for air ventilation, extending outside the holder (20) from the groove (25a, 25b), are provided in the holder.

## Patentansprüche

1. Infrarotsensor (100), umfassend:
ein Infrarotsensorelement (10), welches eine Halbleiterpackung ist, welche einen Sensorchip (1a, 1b) umfasst;
einen optischen Filter (30a, 30b), welcher einer Lichtaufnahmeoberfläche (2a, 2b) des Sensorchips (1a, 1b) gegenüberliegt und angeordnet ist, um die Lichtaufnahmeoberfläche (2a, 2b) des Sensorchips (1a, 1b) abzudecken; und
einen Halter (20), welcher das Infrarotsensorelement und den optischen Filter hält; und
ein Haftmittel (40) zum Bonden des Infrarotsensorelements (10) und des Halters (20),
wobei der Halter enthält
ein vertieftes Aufnahmeteil für einen optischen Filter (21a, 21b) zum Aufnehmen des optischen Filters, welcher auf einer gegenüberliegenden Oberfläche (20a) des Halters (20) vorgesehen ist, welche dem Infrarotsensorelement (10) gegenüberliegt,
**dadurch gekennzeichnet, dass**
der optische Filter (30a, 30b) zwischen dem Halter (20) und dem Infrarotsensorelement (10) eingelegt ist,
wobei eine Haftregion (23), welche ein Vertiefungsteil (23a, 23b) umfasst, an einem Ort entfernt vom Aufnahmeteil für einen optischen Filter auf der gegenüberliegenden Oberfläche (20a) des Halters vorgesehen ist, wobei das Haftmittel in dem vertieften Teil der Haftregion (23) vorgesehen ist, um den Halter (20) und das Infrarotsensorelement (10) miteinander durch das aufgetragene Haftmittel (40) an von dem optischen Filter (30a, 30b) entfernten Orten haftend zu verbinden, und
wobei eine Nut (25a, 25b) zum Halten von Haftmittel, welches aus der Haftregion (23) ausgelaufen ist, innerhalb der Nut zwischen der Haftregion und dem Aufnahmeteil für einen optischen Filter auf der gegenüberliegenden Oberfläche des Halters vorgesehen ist.

2. Infrarotsensor nach Anspruch 1, wobei ein Abstand (d2) von der Oberseite der gegenüberliegenden Oberfläche (20a) des Halters zu einer Bodenfläche der Nut (25a, 25b) größer als der Abstand (d1) von der Oberseite der gegenüberliegenden Oberfläche des Halters zu einer Bodenseite des vertieften Teils (23a, 23b) ist.

3. Infrarotsensor nach Anspruch 1 oder 2, wobei die Nut (25a, 25b) so angeordnet ist, um einen äußeren Umfang des vertieften Teils (23a, 23b) zu umgeben.

4. Infrarotsensor nach einem der Ansprüche 1 bis 3, wobei ein Durchloch (22a, 22b), das einen kleineren Durchmesser als den Durchmesser des Aufnahmeteils für einen optischen Filter (21a, 21b) aufweist, auf einer Bodenfläche des Aufnahmeteils für einen optischen Filter vorgesehen ist.

5. Infrarotsensor nach einem der Ansprüche 1 bis 4, wobei die Öffnungsteile (51a, 51b) zur Luftventilation, welche sich außerhalb des Halters (20) von der Nut (25a, 25b) erstrecken, in dem Halter vorgesehen sind.

## Revendications

1. Capteur infrarouge (100) comprenant :
un élément capteur infrarouge (10), qui est un boîtier semi-conducteur comprenant une puce de détection (1a, 1b);
un filtre optique (30a, 30b) qui fait face à une surface de réception de lumière (2a, 2b) de la puce de détection (1a, 1b) et qui est placé de manière à recouvrir la surface de réception de lumière (2a, 2b) de la puce de détection (1a, 1b) ; et
un support (20) maintenant l'élément capteur infrarouge et le filtre optique ; et
un adhésif (40) pour lier l'élément capteur infrarouge (10) et le support (20),
dans lequel le support inclut
une partie en retrait de logement de filtre optique (21a, 21b) pour loger le filtre optique, ménagée sur une surface en regard (20a) du support (20) qui fait face à l'élément capteur infrarouge (10),
**caractérisé en ce que**
le filtre optique (30a, 30b) est intercalé entre le support (20) et l'élément capteur infrarouge (10),
une zone d'adhésion (23) comprenant une partie en retrait (23a, 23b) est ménagée à un emplacement séparé de la partie de logement de filtre optique sur la surface en regard (20a) du support, l'adhésif étant ménagé sur la partie en retrait de la région d'adhésion (23) de manière à faire adhérer le support (20) et l'élément capteur infrarouge (10) ensemble via l'adhésif appliqué (40) à des emplacements séparés du filtre optique (30a, 30b) ; et
une rainure (25a, 25b) pour maintenir l'adhésif qui fuit de la zone d'adhésion (23) à l'intérieur de ladite rainure est ménagée entre la zone d'adhésion et la partie de logement du filtre optique sur la surface en regard du support.

2. Capteur infrarouge selon la revendication 1, dans lequel une distance (d2) du dessus de la surface en regard (20a) du support à une surface de fond de la rainure (25a, 25b) est supérieure à la distance (d1) du dessus de la surface en regard du support à une surface de fond de la partie en retrait (23a, 23b).

3. Capteur infrarouge selon la revendication 1 ou 2, dans lequel la rainure (25a, 25b) est placée de manière à entourer une circonférence extérieure de la partie en retrait (23a, 23b).

4. Capteur infrarouge selon l'une quelconque des revendications 1 à 3, dans lequel un trou traversant (22a, 22b) ayant un diamètre inférieur au diamètre de la partie de logement de filtre optique (21a, 21b) est ménagé sur une surface de fond de la partie de logement de filtre optique.

5. Capteur infrarouge selon l'une quelconque des revendications 1 à 4, dans lequel des parties d'ouverture (51a, 51b) pour une ventilation d'air, s'étendant à l'extérieur du support (20) depuis la rainure (25a, 25b), sont ménagées dans le support.
